# EUROPEAN PATENT APPLICATION

(11) **EP 4 733 781 A1**
(43) Date of publication of application: **29.04.2026**
(21) Application number: 24849371.0
(22) Date of filing: 24.06.2024
(51) Int. Cl.: G01R 31/36, G01R 31/392, G01R 31/396, G01R 31/367, G06F 17/18

(54) **BATTERY DIAGNOSIS APPARATUS, BATTERY DIAGNOSIS METHOD, AND BATTERY DIAGNOSIS SYSTEM**

(30) Priority: 03.08.2023 KR 20230101779
(71) Applicant: LG Energy Solution, Ltd., Seoul 07335 (KR)
(72) Inventor: KIM, Hae Rin, Daejeon 34122 (KR); KIM, Young Joong, Daejeon 34122 (KR); KOH, Dong Wook, Daejeon 34122 (KR)
(74) Representative: Plasseraud IP
(86) International application number: PCT/KR2024/008701
(87) International publication number: WO 2025/028800

(57) **Abstract**

According to some embodiments disclosed herein, a battery diagnosis apparatus includes a sensor configured to measure battery data from a diagnosis target battery and a controller configured to generate experimental data regarding a lifespan of the diagnosis target battery, based on the battery data, establish a statistical model regarding a state of the diagnosis target battery and a regression model regarding the lifespan of the diagnosis target battery, based on the experimental data, and predict the lifespan of the diagnosis target battery based on the statistical model and the regression model.

## Description

### TECHNICAL FIELD

### CROSS-REFERENCE TO RELATED APPLICATION

This application claims priority to and the benefit of Korean Patent Application No. 10-2023-0101779 filed in the Korean Intellectual Property Office on August 3, 2023, the entire content of which is incorporated herein by reference.

### TECHNICAL FIELD

Embodiments disclosed herein relate to a battery diagnosis apparatus, a battery diagnosis method, and a battery diagnosis system.

### BACKGROUND ART

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Among secondary batteries, lithium-ion batteries may have a higher energy density than conventional Ni/Cd batteries, Ni/MH batteries, etc., and may be manufactured to be small and lightweight, allowing them to have high usability in terms of power sources for mobile devices. Recently, the lithium ion battery is attracting attention as a next-generation energy storage medium as a usage range thereof is expanded to a power source of electric vehicles.

In a process of developing, selling, and guaranteeing batteries, battery lifespan prediction may be important. A tendency of life deterioration may differ with a battery unit such as a cell/module/pack, and when necessary, a lifespan prediction model appropriate for each unit needs to be developed. Generally, due to an influence of cell imbalance, internal resistance, temperature, etc., life deterioration may be accelerated for larger units from cells to modules and to packs. For accurate lifespan prediction, it may be necessary to upgrade a lifespan prediction model first by cell, then by module, and then by pack.

### DISCLOSURE

### TECHNICAL PROBLEM

Embodiments disclosed herein aim to provide a battery diagnosis apparatus, a battery diagnosis method, and a battery diagnosis system, which use a model performing module-based lifespan prediction on the basis of cell-based lifespan prediction.

Technical problems of the embodiments disclosed herein are not limited to the above-described technical problems, and other unmentioned technical problems would be clearly understood by one of ordinary skill in the art from the following description.

### TECHNICAL SOLUTION

According to some embodiments disclosed herein, a battery diagnosis apparatus includes a sensor configured to measure battery data from a diagnosis target battery and a controller configured to generate experimental data regarding a lifespan of the diagnosis target battery, based on the battery data, establish a statistical model regarding a state of the diagnosis target battery and a regression model regarding the lifespan of the diagnosis target battery, based on the experimental data, and predict the lifespan of the diagnosis target battery based on the statistical model and the regression model.

According to some embodiments, the controller may be further configured to generate reference module experimental data regarding a reference battery module of the diagnosis target battery, based on the battery data and generate a plurality of cell experimental data regarding a plurality of battery cells of the reference battery module, based on the battery data.

According to some embodiments, the controller may be further configured to establish the statistical model regarding cell lifespan values of the plurality of battery cells based on the plurality of cell experimental data and establish the regression model regarding a relationship between the cell lifespan values and a module lifespan value of the reference battery module, based on the plurality of cell experimental data and the reference module experimental data.

According to some embodiments, the controller may be further configured to derive a cell lifespan value of a first battery cell among the plurality of battery cells and a cell lifespan value of a second battery cell among the plurality of battery cells, by using the statistical model and derive the module lifespan value of the reference battery module based on the cell lifespan value of the second battery cell, by using the regression model.

According to some embodiments, the controller may be further configured to select a battery cell having a highest cell performance among the plurality of battery cells as the first battery cell and select a battery cell having a lowest cell performance among the plurality of battery cells as the second battery cell.

According to some embodiments, the controller may be further configured to calculate cell performance of each of the plurality of battery cells based on frequency a discharging lower limit voltage is reached.

According to some embodiments, the controller may be further configured to derive module lifespan values of other battery modules of the diagnosis target battery than the reference battery module, by using the regression model.

According to some embodiments, the controller may be further configured to verify model performance of the statistical model and the regression model, based on a result of predicting a lifespan of the diagnosis target battery and update the statistical model and the regression model, based on a result of verifying the model performance.

According to some embodiments disclosed herein, a battery diagnosis method includes measuring battery data from a diagnosis target battery, generating experimental data regarding a lifespan of the diagnosis target battery, based on the battery data, establishing a statistical model regarding a state of the diagnosis target battery and a regression model regarding the lifespan of the diagnosis target battery, based on the experimental data, and predicting the lifespan of the diagnosis target battery based on the statistical model and the regression model.

According to some embodiments, the generating of the experimental data may include generating reference module experimental data regarding a reference battery module of the diagnosis target battery, based on the battery data, and generating a plurality of cell experimental data regarding a plurality of battery cells of the reference battery module.

According to some embodiments, the establishing of the statistical model and the regression model may include establishing the statistical model regarding cell lifespan values of the plurality of battery cells based on the plurality of cell experimental data and establishing the regression model regarding a relationship between the cell lifespan values and a module lifespan value of the reference battery module, based on the plurality of cell experimental data and the reference module experimental data.

According to some embodiments, the predicting of the lifespan of the diagnosis target battery may include deriving a cell lifespan value of a first battery cell among the plurality of battery cells and a cell lifespan value of a second battery cell among the plurality of battery cells, by using the statistical model and deriving the module lifespan value of the reference battery module based on the cell lifespan value of the second battery cell, by using the regression model.

According to some embodiments, the predicting of the lifespan of the diagnosis target battery may include selecting a battery cell having a highest cell performance among the plurality of battery cells as the first battery cell and selecting a battery cell having a lowest cell performance among the plurality of battery cells as the second battery cell.

According to some embodiments, the predicting of the lifespan of the diagnosis target battery may include calculating cell performance of each of the plurality of battery cells based on frequency a discharging lower limit voltage is reached.

According to some embodiments, deriving module lifespan values of other battery modules of the diagnosis target battery than the reference battery module, by using the regression model.

According to some embodiments, the battery diagnosis method may further include verifying model performance of the statistical model and the regression model, based on a result of predicting a lifespan of the diagnosis target battery and updating the statistical model and the regression model, based on a result of verifying the model performance.

According to some embodiments disclosed herein, a battery diagnosis system includes a diagnosis target battery, a charger/discharger configured to charge or discharge the diagnosis target battery, a battery diagnosis apparatus configured to measure battery data from a diagnosis target battery, generate experimental data regarding a lifespan of the diagnosis target battery, based on the battery data, establish a statistical model regarding a state of the diagnosis target battery and a regression model regarding the lifespan of the diagnosis target battery, based on the experimental data, and predict the lifespan of the diagnosis target battery based on the statistical model and the regression model, and a management server configured to manage a lifespan of the diagnosis target battery.

According to some embodiments, the battery diagnosis apparatus may be further configured to generate reference module experimental data regarding a reference battery module of the diagnosis target battery, based on the battery data and generate a plurality of cell experimental data regarding a plurality of battery cells of the reference battery module, based on the battery data.

According to some embodiments, the battery diagnosis apparatus may be further configured to establish the statistical model regarding cell lifespan values of the plurality of battery cells based on the plurality of cell experimental data and establish the regression model regarding a relationship between the cell lifespan values and a module lifespan value of the reference battery module, based on the plurality of cell experimental data and the reference module experimental data.

According to some embodiments, the battery diagnosis apparatus may be further configured to derive a cell lifespan value of a first battery cell among the plurality of battery cells and a cell lifespan value of a second battery cell among the plurality of battery cells, by using the statistical model and derive the module lifespan value of the reference battery module based on the cell lifespan value of the second battery cell, by using the regression model.

According to some embodiments, the battery diagnosis apparatus may be further configured to select a battery cell having a highest cell performance among the plurality of battery cells as the first battery cell and select a battery cell having a lowest cell performance among the plurality of battery cells as the second battery cell.

According to some embodiments, the battery diagnosis apparatus may be further configured to calculate cell performance of each of the plurality of battery cells based on frequency a discharging lower limit voltage is reached.

According to some embodiments, the battery diagnosis apparatus may be further configured to derive module lifespan values of other battery modules of the diagnosis target battery than the reference battery module, by using the regression model.

According to some embodiments, the battery diagnosis apparatus may be further configured to verify model performance of the statistical model and the regression model, based on a result of predicting a lifespan of the diagnosis target battery and update the statistical model and the regression model, based on a result of verifying the model performance.

### ADVANTAGEOUS EFFECTS

According to embodiments disclosed herein, there may be provided a battery diagnosis apparatus, a battery diagnosis method, and a battery diagnosis system, which use a model performing module-based lifespan prediction on the basis of cell-based lifespan prediction.

The technical effects according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 illustrates components of a battery diagnosis system according to some embodiments.
FIG. 2 illustrates components of a battery diagnosis apparatus according to some embodiments.
FIG. 3 illustrates a difference between a model establishment scheme of a battery diagnosis apparatus according to some embodiments and a conventional model establishment scheme.
FIG. 4 illustrates a process of establishing a statistical model with respect to a state of a diagnosis target battery, according to some embodiments.
FIG. 5 illustrates a process of establishing a regression model with respect to a lifespan of a diagnosis target battery, according to some embodiments.
FIG. 6 illustrates experimental data with respect to a lifespan of a battery cell according to some embodiments.
FIG. 7 illustrates a process of deriving minimum cell lifespan and module lifespan by applying a statistical model and a regression model, according to some embodiments.
FIG. 8 illustrates a process of deriving a module lifespan based on a cell lifespan on the basis of a statistical model and a regression model, according to some embodiments.
FIG. 9 illustrates operations of a battery diagnosis method according to some embodiments.

### MODE FOR INVENTION

Hereinafter, embodiments disclosed herein will be described with reference to the accompanying drawings. However, the description is not intended to limit the disclosure of the present document to particular embodiments, and it should be construed as including various modifications, equivalents, and/or alternatives according to the embodiments described herein.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

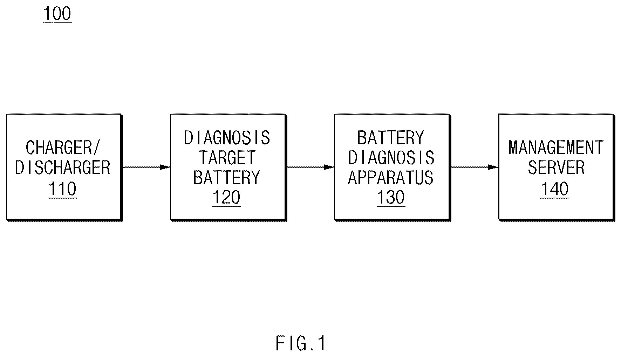

FIG. 1 illustrates components of a battery diagnosis system according to some embodiments.

Referring to FIG. 1, a battery diagnosis system 100 may include a charger/discharger 110, a diagnosis target battery 120, a battery diagnosis apparatus 130, and a management server 140. However, without being limited thereto, some components may be omitted from the battery diagnosis system 100 or other general-purpose components may be further included in the battery diagnosis system 100.

The battery diagnosis system 100 may refer to a system for diagnosing the diagnosis target battery 120. When a test voltage is applied to the diagnosis target battery 120 by the charger/discharger 110, a response of the diagnosis target battery 120 thereto may be measured and analyzed by the battery diagnosis apparatus 130.

The charger/discharger 110 may be configured to charge or discharge the diagnosis target battery 120. The charger/discharger 110 may apply a charging/discharging voltage and/or a charging/discharging current to the diagnosis target battery 120, and the charging/discharging voltage/current may include a test cycle voltage/current for test charging/discharging. For example, the charger/discharger 110 may include a power supply device for providing a waveform of a voltage/current in various forms.

The diagnosis target battery 120 may include a battery pack, etc., that is a target for diagnosis of the battery diagnosis system 100. The diagnosis target battery 120 may include a plurality of battery modules, and each battery module may include a plurality of battery cells. The plurality of battery modules of the diagnosis target battery 120 may include a reference battery module and the other battery modules, and lifespan diagnosis for the other battery modules may be performed based on experimental data regarding an existing battery module.

The battery diagnosis apparatus 130 may perform operations for diagnosing the diagnosis target battery 120. The battery diagnosis apparatus 130 may measure battery data from the diagnosis target battery 120 and predict a cell-based lifespan and a module-based lifespan based on the battery data.

The management server 140 may manage a result of diagnosis of the battery diagnosis apparatus 130. The management server 140 may exchange data with the battery diagnosis apparatus 130 in a wired/wireless communication manner. When the cell/module-based lifespan of the diagnosis target battery 120 is predicted, their values may be transmitted to the management server 140 and recorded in a database. According to an embodiment, the management server 140 may perform operations for diagnosing the diagnosis target battery 120, in place of the battery diagnosis apparatus 130. According to an embodiment, the battery diagnosis apparatus 130 may perform diagnosis operations by executing battery management software, and the management server 140 may provide update information of the battery management software to the battery diagnosis apparatus 130.

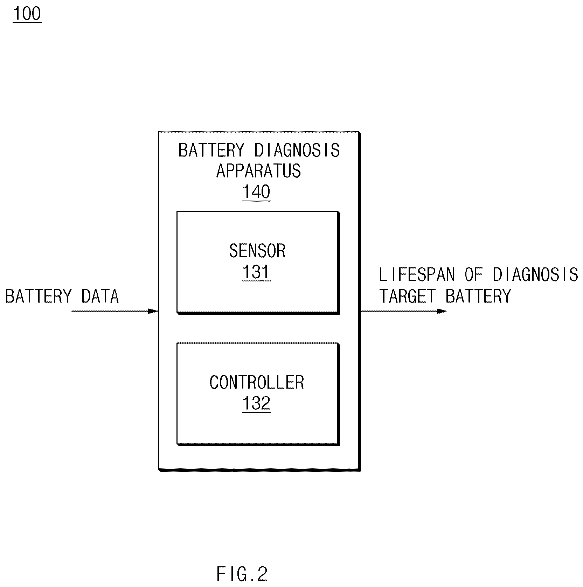

FIG. 2 illustrates components of a battery diagnosis apparatus according to some embodiments.

Referring to FIG. 2, the battery diagnosis apparatus 130 may include a sensor 131 and a controller 132. However, without being limited thereto, some components may be omitted from the battery diagnosis apparatus 130 or other general-purpose components may be further included in the battery diagnosis apparatus 130.

According to an embodiment, the sensor 131 and the controller 132 of the battery diagnosis apparatus 130 may be electrically connected to one another in a device-to-device communication manner. The device-to-device communication manner may include a general-purpose input and output (GPIO), a serial peripheral interface (SPI), a mobile industry processor interface (MIPI), etc.

The sensor 131 may be configured to generate various battery measurement values from the diagnosis target battery 120. To this end, the sensor 131 may include measuring means such as a voltmeter, an ammeter, a thermometer, etc.

The controller 132 may have a structure for executing instructions that implement the operations of the battery diagnosis apparatus 130. The controller 132 may be implemented with an array of multiple logic gates or a general-purpose microprocessor for processing various operations, and may include a single processor or a plurality of processors. For example, the controller 132 may be implemented in the form of at least one of a microprocessor, a CPU, a GPU, and an AP.

The controller 132 may operate with a memory configured to store various data, instructions, mobile applications, computer programs, etc. The memory may be configured separately from or integrally with the controller 132. The controller 132 may execute instructions stored in the memory to process various calculation. For example, the memory may be implemented in the form of a non-volatile memory device such as ROM, PROM, EPROM, EEPROM, flash memory, PRAM, MRAM, RRAM, FRAM, etc., or a volatile memory device such as DRAM, SRAM, SDRAM, RRAM, HDD, SSD, SD, Micro- SD, etc., or may be implemented in the form of a combination thereof.

The sensor 131 of the battery diagnosis apparatus 130 may be configured to measure the battery data from the diagnosis target battery 120. When the test voltage and/or current is applied to the diagnosis target battery 120 by the charger/discharger 110, a voltage, a current, a temperature, etc., of the diagnosis target battery 120 may be changed in response thereto and may be measured by the sensor 131. According to an embodiment, the sensor 131 may measure cell-based battery data and module-based battery data of the diagnosis target battery 120.

The controller 132 of the battery diagnosis apparatus 130 may be configured to generate experimental data regarding a lifespan of the diagnosis target battery 120 based on the battery data. When the experimental data regarding the lifespan is generated, a separate lifespan prediction for predicting a battery lifespan from the battery data may be used. According to an embodiment, the lifespan prediction model may be provided from the management server 140. According to an embodiment, the experimental data regarding the lifespan of the diagnosis target battery 120 may indicate a trend of change in battery lifespan over time or as a charging/discharging cycle progresses, and the experimental data may be generated on a cell or module basis.

The controller 132 of the battery diagnosis apparatus 130 may be configured to establish a statistical model for a state of the diagnosis target battery 120 and a lifespan of the diagnosis target battery 120 on the basis of the experimental data. According to an embodiment, the statistical model may mean a model regarding a statistical relationship between lifespan values of battery cells of the diagnosis target battery 120, and the regression model may mean a model expressing a relationship between a lifespan of a specific battery cell and a lifespan of a battery module including the same on the basis of regression. According to an embodiment, the statistical model and the regression model may be expressed in the form of an equation or a function.

The controller 132 of the battery diagnosis apparatus 130 may be configured to predict a lifespan of the diagnosis target battery 120 based on the statistical model and the regression model. When the statistical model and the regression model are established based on the experimental data, lifespan prediction may be performed using the statistical model and the regression model. According to an embodiment, when the lifespan of any one battery cell of the diagnosis target battery 120 is input to the statistical model and the regression model, a module lifespan prediction value of a battery module including the battery cell may be output.

According to an embodiment, the controller 132 of the battery diagnosis apparatus 130 may be configured to generate reference module experimental data regarding a reference battery module of the diagnosis target battery 120 based on the battery data and generate a plurality of cell experimental data regarding a plurality of battery cells of the reference battery module based on the battery data. Unlike in a conventional lifespan prediction model that needs separate experimental data regarding all battery modules of the diagnosis target battery 120, the battery diagnosis apparatus 130 may need experimental data merely for one reference battery module and, when a statistical model and a regression model are established based on the experimental data, they may be used for the other battery modules.

According to an embodiment, the controller 132 of the battery diagnosis apparatus 130 may be configured to establish a statistical model for cell lifespan values of the plurality of battery cells based on the plurality of cell experimental data and establish a regression model regarding a relationship between the cell lifespan values and a module lifespan value of the reference battery module based on the plurality of cell experimental data and the reference module experimental data. According to an embodiment, the statistical model may be a model regarding a statistical relationship between the cell lifespan values of the plurality of battery cells, and the regression model may be a model regarding a regression relationship between one battery cell lifespan and a module lifespan.

According to an embodiment, the controller 132 of the battery diagnosis apparatus 130 may be configured to derive a cell lifespan value of a second battery cell among a plurality of battery cells based on a cell lifespan value of a first battery cell among the plurality of battery cells by using the statistical model, and derive the module lifespan value of the reference battery module based on the cell lifespan value of the second battery cell by using the regression model. According to an embodiment, the statistical model may specify a statistical relationship between the lifespan value of the first battery cell and the lifespan value of the second battery cell among the plurality of battery cells, and upon input of the lifespan value of the first battery cell into the statistical model, the lifespan value of the second battery cell may be output. The regression model may specify a relationship between the lifespan value of the second battery cell and the module lifespan value of the reference battery module.

According to an embodiment, the controller 132 of the battery diagnosis apparatus 130 may be configured to select a battery cell having the highest cell performance among the plurality of battery cells as the first battery cell and select a battery cell having the lowest cell performance among the plurality of battery cells as the second battery cell. After the plurality of battery cells are arranged based on cell performance, the battery cell having the highest performance may be selected as the first battery cell and the battery cell having the lowest performance may be selected as the second battery cell.

According to an embodiment, the controller 132 of the battery diagnosis apparatus 130 may be configured to calculate cell performance of each of the plurality of battery cells based on frequency a discharging lower limit voltage is reached. According to an embodiment, the battery data measured from the diagnosis target battery 120 may include cell voltage data, and when the experimental data regarding the lifespan of the diagnosis target battery 120 is generated, the number of times and frequency the cell voltage reaches the discharging lower limit voltage may be analyzed. As the frequency the discharging lower limit voltage is reached increases, a battery lifespan and cell performance may decrease, and a cell having the highest frequency may be selected as the second battery cell.

According to an embodiment, the controller 132 of the battery diagnosis apparatus 130 may be configured to derive module lifespan values of the other battery modules of the diagnosis target battery 120 than the reference battery module, by using the regression model. Unlike in a conventional lifespan prediction model that needs experimental data regarding all battery modules, the battery diagnosis apparatus 130 may generate experimental data merely for one reference battery module, generate the statistical model and the regression model based on the experimental data, and predict lifespans of the other battery modules by using the statistical model and the regression model without generating additional experimental data.

According to an embodiment, the controller 132 of the battery diagnosis apparatus 130 may be further configured to verify model performance of the statistical model and the regression model based on a result of predicting the lifespan of the diagnosis target battery 120 and update the statistical model and the regression model based on a result of verifying the model performance. For example, when the statistical model and the regression model have low lifespan prediction accuracy for a battery module having a specific condition, the statistical model and the regression model may be updated or the experimental data may be newly generated to compensate for the low accuracy. Verification of the model performance may be performed by comparing model prediction values with an actually measured value or a standard value.

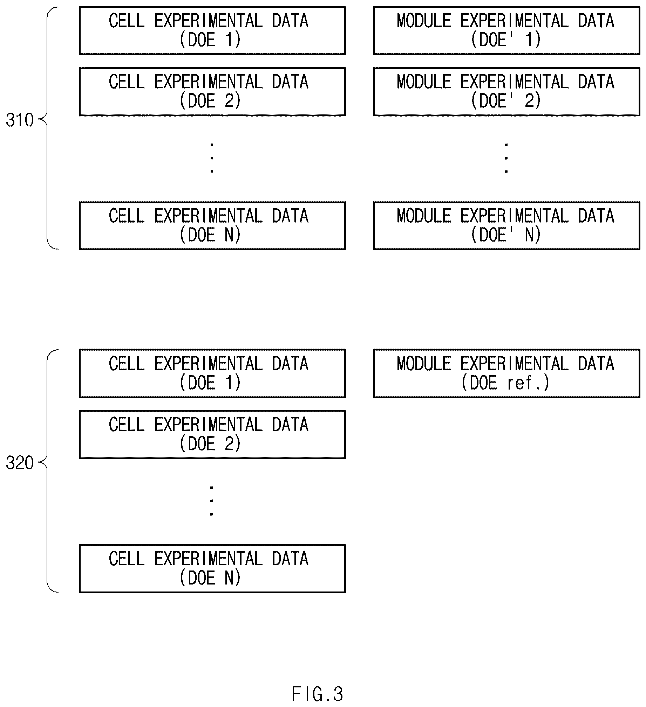

FIG. 3 illustrates a difference between a model establishment scheme of a battery diagnosis apparatus according to some embodiments and a conventional model establishment scheme.

Referring to FIG. 3, a conventional model establishment scheme 310 and a model establishment scheme 320 of the battery diagnosis apparatus 130 are shown. A difference between the two schemes may be related to whether experimental data is generated for all the battery modules.

The conventional model establishment scheme 310 may need experimental data according to a design of experiment (DOE) for all the battery modules as well as experimental data regarding the plurality of battery cells. Unlike experiment for a battery cell, much cost may be required for performing high-temperature storage experiment on a battery module, such that it may be difficult to obtain experimental data regarding all the battery modules.

For the model establishment scheme 320 of the battery diagnosis apparatus 130, module experimental data (DOE ref.) may be generated merely for one reference battery module among the battery modules of the diagnosis target battery 120, and experimental data regarding the other battery modules may not be generated. When the statistical model and the regression model are established based on the reference battery module, lifespan prediction may be performed on the other battery modules by using the statistical model and the regression model.

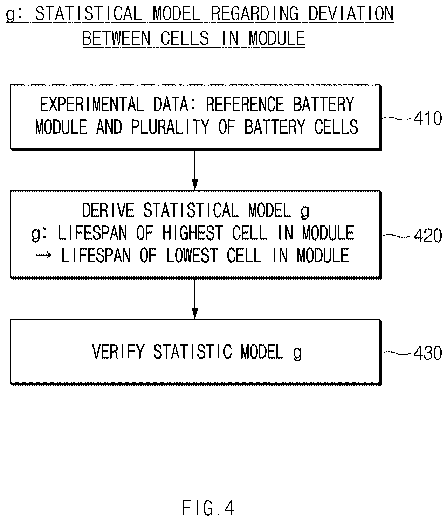

FIG. 4 illustrates a process of establishing a statistical model with respect to a state of a diagnosis target battery, according to some embodiments.

Referring to FIG. 4, a process of establishing a statistical model g regarding a state of the diagnosis target battery 120 may include a data providing operation 410, a model generating operation 420, and a model verifying operation 430.

In the data providing operation 410, experimental data regarding one reference battery module and a plurality of battery cells of the reference battery module may be generated. The experimental data may be generated based on battery data measured from a cell/module. According to an embodiment, battery cells belonging to two or more battery modules may be a basis for generating the experimental data.

In the model generating operation 420, the statistical model g regarding a statistical relationship between cell lifespan values of the plurality of battery cells may be generated. According to an embodiment, the statistical model g may model a lifespan deviation of cells in a module, and when the lifespan of the highest cell in the module is input to the statistical model g, the lifespan of the lowest cell in the model may be output from the statistical model g. According to an embodiment, the highest cell and the lowest cell may be selected based on cell performance which may be calculated based on the number of times and/or frequency the discharging lower limit voltage is reached. A detailed type of the statistical model g may include a type known in related technical fields.

In the model verifying operation 430, the model performance of the statistical model g may be verified, and model parameters of the statistical model g may be adjusted based on a verification result. According to an embodiment, in a process of verifying the statistical model g, a sigma point covering the experimental data may be selected.

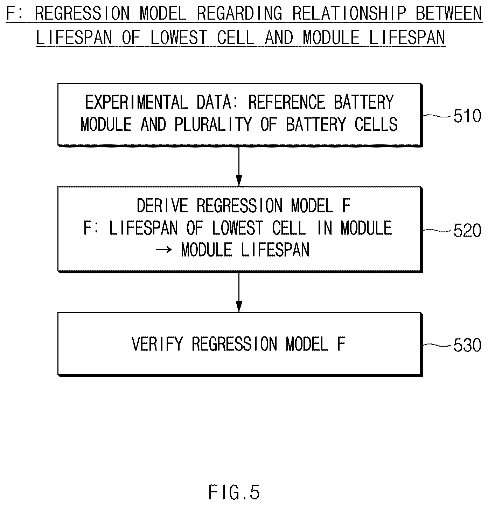

FIG. 5 illustrates a process of establishing a regression model with respect to a lifespan of a diagnosis target battery, according to some embodiments.

Referring to FIG. 5, a process of establishing a regression model f regarding a lifespan of the diagnosis target battery 120 may include a data providing operation 510, a model generating operation 520, and a model verifying operation 530.

In the data providing operation 510, experimental data regarding a reference battery module and a plurality of battery cells of the reference battery module of the diagnosis target battery 120 may be generated. In the model generating operation 520, the regression model f regarding a relationship between a cell lifespan in a module and a module lifespan may be derived. According to an embodiment, the regression model f may derive module performance of the reference battery module based on a lifespan of a cell having the lowest performance in the reference battery module. In the model verifying operation 530, the performance of the regression model f may be verified by comparing a prediction value with an actually measured value/reference value, and model parameters of the regression model f may be updated in case of insufficient performance.

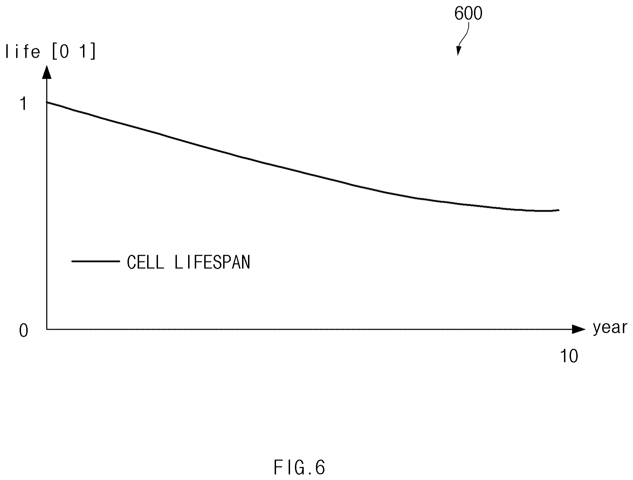

FIG. 6 illustrates experimental data with respect to a lifespan of a battery cell according to some embodiments.

Referring to FIG. 6, a graph 500 is shown which illustrates experimental data regarding a lifespan of a battery cell. The graph 600 may present a lifespan along a vertical axis with respect to a time (year) along a horizontal axis.

When battery data is measured from the diagnosis target battery 120, a cell lifespan and a module lifespan may be derived by applying a battery lifespan prediction model to the battery data. The battery lifespan prediction model may be provided from the management server 140. The cell lifespan and the module lifespan may be experimental data for generating the statistical model and the regression model.

The graph 600 may indicate a lifespan of any one of the plurality of battery cells of the reference battery module. According to an embodiment, an indicator indicating a degradation rate may include SOH-OCV and may further include other types of indicators. The SOH-OCV indicator may mean a degradation rate of a theoretical capacity except for an overpotential in a voltage range of a battery cell and may be expressed as a value between 0 and 1.

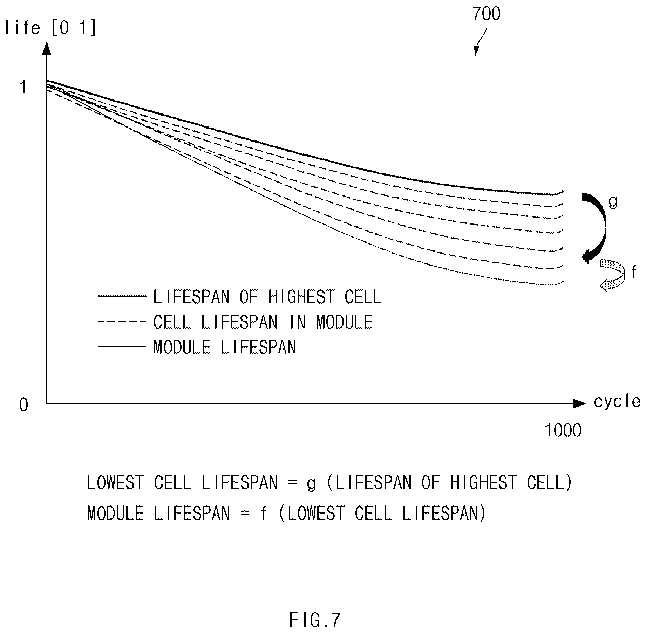

FIG. 7 illustrates a process of deriving minimum cell lifespan and module lifespan by applying a statistical model and a regression model, according to some embodiments.

Referring to FIG. 7, a graph 700 is shown which illustrates a process of deriving the lowest cell lifespan and a module lifespan by applying a statistical model and a regression model. The graph 700 may show a battery lifespan along the vertical axis with respect to a charging/discharging cycle along the horizontal axis.

The graph 700 may show a cell lifespan of each of the plurality of battery cells of the reference battery module and also a module lifespan of the reference battery module. The uppermost curve among cell lifespan curves of the plurality of battery cells may mean a lifespan curve of the highest-performance cell, and the lowermost curve may mean a lifespan curve of the lowest-performance cell. As is shown, when the statistical model g is applied to the lifespan of the highest-performance cell, the lifespan of the lowest-performance cell may be derived.

When the regression model f is applied to the lowest-performance cell, the module lifespan of the battery module may be derived. Generally, the module lifespan of the battery module may be shorter than the cell lifespan of the lowest-performance cell in a module. Through the regression model f specifying the regression relationship regarding the same, the module lifespan may be predicted.

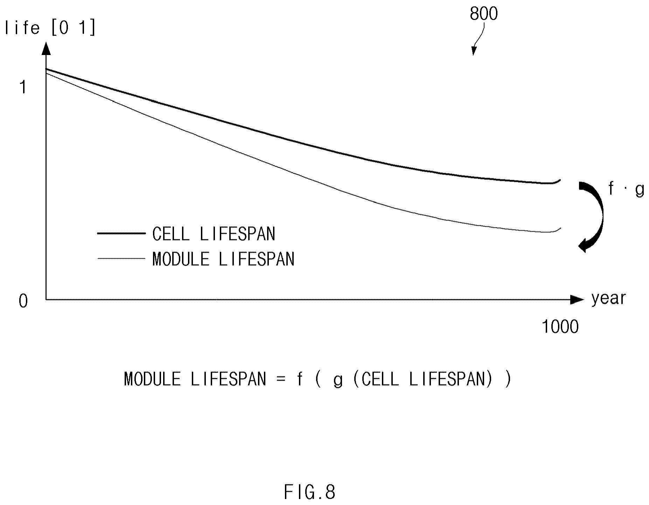

FIG. 8 illustrates a process of deriving a module lifespan based on a cell lifespan on the basis of a statistical model and a regression model, according to some embodiments.

Referring to FIG. 8, a graph 800 is shown which illustrates a process of deriving a module lifespan based on a cell lifespan based on a statistical model and a regression model. The graph 800 may present a lifespan along a vertical axis with respect to a time (year) along a horizontal axis.

In the graph 800, when a lifespan of a cell belonging to a diagnosis target module is given, the statistical model g and the regression model f may be sequentially applied thereto, and as a result, a module lifespan of the diagnosis target module may be predicted. Meanwhile, the cell lifespan used for prediction of the module lifespan may be a lifespan of a cell having the highest performance in a module. According to an embodiment, based on the statistical model g, lifespans of the other cells than the highest performance cell may be used as inputs for prediction of a module lifespan.

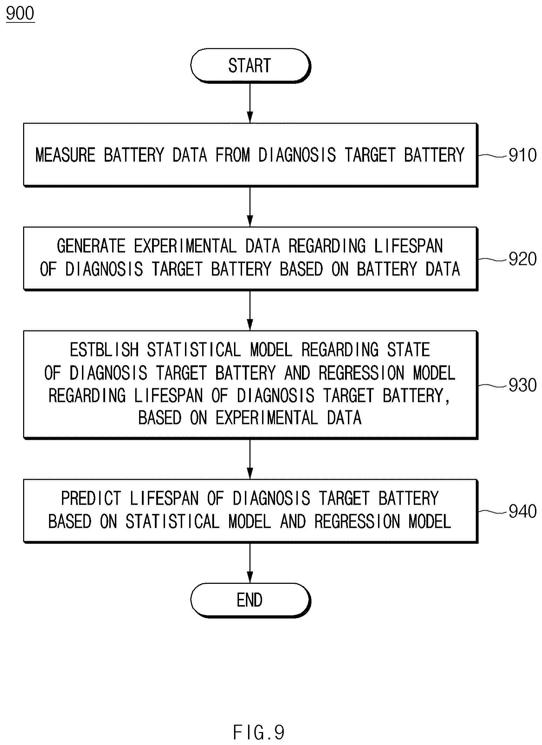

FIG. 9 illustrates operations of a battery diagnosis method according to some embodiments.

Referring to FIG. 9, the battery diagnosis method 900 may include operations 910 to 940. However, without being limited thereto, some operations may be omitted and other general-purpose operations may be added, and operations of the battery diagnosis method 900 may be executed in an order different from that shown.

The battery diagnosis method 900 may include operations processed in time series by the battery diagnosis apparatus 130. Therefore, matters described for the battery diagnosis apparatus 130 above, even omitted below, may be equally applied to the battery diagnosis method 900.

Operations 910 to 940 of the battery diagnosis method 900 may be performed by the sensor 131 and the controller 132 of the battery diagnosis apparatus 130.

In operation 910, the battery diagnosis apparatus 130 may measure battery data from a diagnosis target battery.

In operation 920, the battery diagnosis apparatus 130 may generate experimental data regarding a lifespan of the diagnosis target battery, based on battery data.

In operation 930, the battery diagnosis apparatus 130 may establish a statistical model regarding a state of the diagnosis target battery and a regression model regarding the lifespan of the diagnosis target battery, based on experimental data.

In operation 940, the battery diagnosis apparatus 130 may predict the lifespan of the diagnosis target battery based on the statistical model and the regression model.

According to an embodiment, the battery diagnosis method 900 may be implemented in the form of a computer program stored in a computer-readable storage medium. That is, the computer program may include instructions for implementing the battery diagnosis method 900, and the instructions of the program may be stored in a computer-readable storage medium. The computer programs may include mobile applications.

According to an embodiment, the computer-readable storage medium may include magnetic media such as hard disk, floppy disk, and magnetic tape, optical media such as compact disk read only memory (CD-ROM) and digital versatile disk (DVD), magneto-optical media such as floptical disk, and a hardware device especially configured to store and execute program instructions, such as read only memory (ROM), random access memory (RAM) and flash memory, etc. The computer program instructions may include a machine language code created by a complier and a high-level language code executable by a computer using an interpreter.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

### [Description of Symbols]

| | | | |
|---|---|---|---|
| 100: | Battery Diagnosis System | 110: | Charger/Discharger |
| 120: | Diagnosis Target Battery | 130: | Battery Diagnosis Apparatus |
| 131: | Sensor | 132: | Controller |
| 140: | Management Server | | |

## Claims

1. A battery diagnosis apparatus comprising:
a sensor configured to measure battery data from a diagnosis target battery; and
a controller configured to:
generate experimental data regarding a lifespan of the diagnosis target battery, based on the battery data;
establish a statistical model regarding a state of the diagnosis target battery and a regression model regarding the lifespan of the diagnosis target battery, based on the experimental data; and
predict the lifespan of the diagnosis target battery based on the statistical model and the regression model.

2. The battery diagnosis apparatus of claim 1, wherein the controller is further configured to:
generate reference module experimental data regarding a reference battery module of the diagnosis target battery, based on the battery data; and
generate a plurality of cell experimental data regarding a plurality of battery cells of the reference battery module, based on the battery data.

3. The battery diagnosis apparatus of claim 2, wherein the controller is further configured to:
establish the statistical model regarding cell lifespan values of the plurality of battery cells based on the plurality of cell experimental data; and
establish the regression model regarding a relationship between the cell lifespan values and a module lifespan value of the reference battery module, based on the plurality of cell experimental data and the reference module experimental data.

4. The battery diagnosis apparatus of claim 3, wherein the controller is further configured to:
derive a cell lifespan value of a first battery cell among the plurality of battery cells and a cell lifespan value of a second battery cell among the plurality of battery cells, by using the statistical model; and
derive the module lifespan value of the reference battery module based on the cell lifespan value of the second battery cell, by using the regression model.

5. The battery diagnosis apparatus of claim 4, wherein the controller is further configured to:
select a battery cell having a highest cell performance among the plurality of battery cells as the first battery cell; and
select a battery cell having a lowest cell performance among the plurality of battery cells as the second battery cell.

6. The battery diagnosis apparatus of claim 5, wherein the controller is further configured to calculate cell performance of each of the plurality of battery cells based on frequency a discharging lower limit voltage is reached.

7. The battery diagnosis apparatus of claim 4, wherein the controller is further configured to derive module lifespan values of other battery modules of the diagnosis target battery than the reference battery module, by using the regression model.

8. The battery diagnosis apparatus of claim 1, wherein the controller is further configured to:
verify model performance of the statistical model and the regression model, based on a result of predicting a lifespan of the diagnosis target battery; and
update the statistical model and the regression model, based on a result of verifying the model performance.

9. A battery diagnosis method comprising:
measuring battery data from a diagnosis target battery;
generating experimental data regarding a lifespan of the diagnosis target battery, based on the battery data;
establishing a statistical model regarding a state of the diagnosis target battery and a regression model regarding the lifespan of the diagnosis target battery, based on the experimental data; and
predicting the lifespan of the diagnosis target battery based on the statistical model and the regression model.

10. The battery diagnosis method of claim 9, wherein the generating of the experimental data comprises:
generating reference module experimental data regarding a reference battery module of the diagnosis target battery, based on the battery data; and
generating a plurality of cell experimental data regarding a plurality of battery cells of the reference battery module.

11. The battery diagnosis method of claim 10, wherein the establishing of the statistical model and the regression model comprises:
establishing the statistical model regarding cell lifespan values of the plurality of battery cells based on the plurality of cell experimental data; and
establishing the regression model regarding a relationship between the cell lifespan values and a module lifespan value of the reference battery module, based on the plurality of cell experimental data and the reference module experimental data.

12. The battery diagnosis method of claim 11, wherein the predicting of the lifespan of the diagnosis target battery comprises:
deriving a cell lifespan value of a first battery cell among the plurality of battery cells and a cell lifespan value of a second battery cell among the plurality of battery cells, by using the statistical model; and
deriving the module lifespan value of the reference battery module based on the cell lifespan value of the second battery cell, by using the regression model.

13. The battery diagnosis method of claim 12, wherein the predicting of the lifespan of the diagnosis target battery comprises:
selecting a battery cell having a highest cell performance among the plurality of battery cells as the first battery cell; and
selecting a battery cell having a lowest cell performance among the plurality of battery cells as the second battery cell.

14. The battery diagnosis method of claim 13, wherein the predicting of the lifespan of the diagnosis target battery comprises calculating cell performance of each of the plurality of battery cells based on frequency a discharging lower limit voltage is reached.

15. The battery diagnosis method of claim 12, wherein the predicting of the lifespan of the diagnosis target battery comprises deriving module lifespan values of other battery modules of the diagnosis target battery than the reference battery module, by using the regression model.

16. The battery diagnosis method of claim 9, further comprising:
verifying model performance of the statistical model and the regression model, based on a result of predicting a lifespan of the diagnosis target battery; and
updating the statistical model and the regression model, based on a result of verifying the model performance.

17. A battery diagnosis system comprising:
a diagnosis target battery;
a charger/discharger configured to charge or discharge the diagnosis target battery;
a battery diagnosis apparatus configured to measure battery data from a diagnosis target battery, generate experimental data regarding a lifespan of the diagnosis target battery, based on the battery data, establish a statistical model regarding a state of the diagnosis target battery and a regression model regarding the lifespan of the diagnosis target battery, based on the experimental data, and predict the lifespan of the diagnosis target battery based on the statistical model and the regression model; and
a management server configured to manage a lifespan of the diagnosis target battery.

18. The battery diagnosis system of claim 17, wherein the battery diagnosis apparatus is further configured to:
generate reference module experimental data regarding a reference battery module of the diagnosis target battery, based on the battery data; and
generate a plurality of cell experimental data regarding a plurality of battery cells of the reference battery module, based on the battery data.

19. The battery diagnosis system of claim 18, wherein the battery diagnosis apparatus is further configured to:
establish the statistical model regarding cell lifespan values of the plurality of battery cells based on the plurality of cell experimental data; and
establish the regression model regarding a relationship between the cell lifespan values and a module lifespan value of the reference battery module, based on the plurality of cell experimental data and the reference module experimental data.

20. The battery diagnosis system of claim 19, wherein the battery diagnosis apparatus is further configured to:
derive a cell lifespan value of a first battery cell among the plurality of battery cells and a cell lifespan value of a second battery cell among the plurality of battery cells, by using the statistical model; and
derive the module lifespan value of the reference battery module based on the cell lifespan value of the second battery cell, by using the regression model.
